# EUROPEAN PATENT APPLICATION

(11) **EP 4 390 511 A1**
(43) Date of publication of application: **26.06.2024**
(21) Application number: 23794231.3
(22) Date of filing: 24.10.2023
(51) Int. Cl.: G02B 27/01, G02B 7/02, H04N 23/57, H04N 13/332, H04N 13/366, H05K 1/18

(54) **WEARABLE ELECTRONIC DEVICE COMPRISING CAMERA MODULE**

(30) Priority: 07.11.2022 KR 20220146811; 02.12.2022 KR 20220166793
(71) Applicant: Samsung Electronics Co., Ltd., Suwon-si, Gyeonggi-do 16677 (KR)
(72) Inventor: The designation of the inventor has not yet been filed
(74) Representative: Gulde & Partner
(86) International application number: PCT/KR2023/016529
(87) International publication number: WO 2024/101718

(57) **Abstract**

According to an embodiment of the disclosure, a wearable electronic device may include a housing including an opening formed there through, a display module disposed in the housing and configured to output a visual image, a battery disposed in the housing, a camera module disposed in the opening and including a first groove formed to be recessed on at least a part of a side surface of the camera module, and a camera support member configured to fix the camera module to the housing. Various other embodiments are possible.

## Description

### [Technical Field]

Various embodiments disclosed herein relate to a wearable electronic device and, for example, to a wearable electronic device including a camera module.

### [Background Art]

A portable electronic device, for example, an electronic notebook, a portable multimedia player, a mobile communication terminal, or a tablet PC, is generally equipped with a display member and a battery, and due to the shape of the display member or the battery, the electronic device has a bar-type, folder-type, or sliding-type appearance. Recently, as a display member and a battery have improved in performance and are miniaturized, a wearable electronic device which is able to be worn on parts of the body such as the wrist or head has been commercialized. The wearable electronic device may be directly worn on the body, and thus portability and/or user accessibility may be improved.

Among wearable electronic devices, an electronic device which is able to be worn on the face by a user, for example, a head-mounted device (HMD) is disclosed. The head-mounted device may be usefully used in implementing virtual reality or augmented reality. For example, a wearable electronic device may provide a three-dimensional image of a virtual space in a game enjoyed via a television or a computer monitor, while blocking the image of the real space where the user is staying, thereby realizing virtual reality. Another type of a wearable electronic device may implement a virtual image, while providing an environment in which a user is able to visually perceive a real image of a space in which the user is staying, to provide augmented reality that provides various visual information to the user.

### [Detailed Description of the Invention]

### [Technical Solution]

According to an embodiment of the disclosure, a wearable electronic device includes a housing including an opening, a display module disposed in the housing and configured to output a visual image, a battery disposed in the housing, a camera module disposed in the opening and including a first groove formed to be recessed on at least a part of a side surface of the camera module, and a camera support member configured to fix the camera module to the housing, wherein the camera support member includes body portions formed to surround at least a part of the camera module and at least one protrusion protruding from at least a part of the body portions to be inserted into the first groove.

According to an embodiment of the disclosure, a wearable electronic device may include a housing including an opening formed at a portion adjacent to an edge of the housing, at least one wearing member foldably connected to the housing, a display module disposed in the housing and configured to output a visual image, a battery disposed in the housing, a camera module disposed in the opening and including a first groove formed to be recessed on at least a part of a side surface of the camera module, and a camera support member configured to fix the camera module to the housing, wherein the camera support member includes body portions formed to surround at least a part of the camera module and at least one protrusion protruding from at least a part of the body portions to be inserted into the first groove.

### [Brief Description of Drawings]

FIG. 1 is a block diagram of an electronic device in a network environment, according to various embodiments;
FIG. 2 is a front perspective view of a wearable electronic device, according to an embodiment of the disclosure;
FIG. 3 is a rear perspective view of a wearable electronic device, according to an embodiment of the disclosure;
FIG. 4 is a front view of a wearable electronic device, according to an embodiment of the disclosure;
FIG. 5 is an exploded perspective view of a wearable electronic device, according to an embodiment of the disclosure;
FIG. 6 is a rear view showing a front case and a plurality of camera modules, according to an embodiment of the disclosure;
FIG. 7 is a perspective view showing a state before a front case and a camera module are coupled to each other, according to an embodiment of the disclosure;
FIG. 8 is a plan view showing a state in which a front case and a camera module are coupled to each other, according to an embodiment of the present disclosure;
FIG. 9 is a perspective view showing a camera module, a camera support member, and a flexible printed circuit board, according to an embodiment of the disclosure;
FIG. 10 is a plan view showing a camera module and a camera support member , according to an embodiment of the disclosure;
FIG. 11 is a cross-sectional view of the wearable electronic device, taken along line A-A of FIG. 4, according to an embodiment of the disclosure; and
FIG. 12 is a cross-sectional view of the wearable electronic device, taken along line A-A of FIG. 4, according to an embodiment of the disclosure.

### [Mode for Carrying out the Invention]

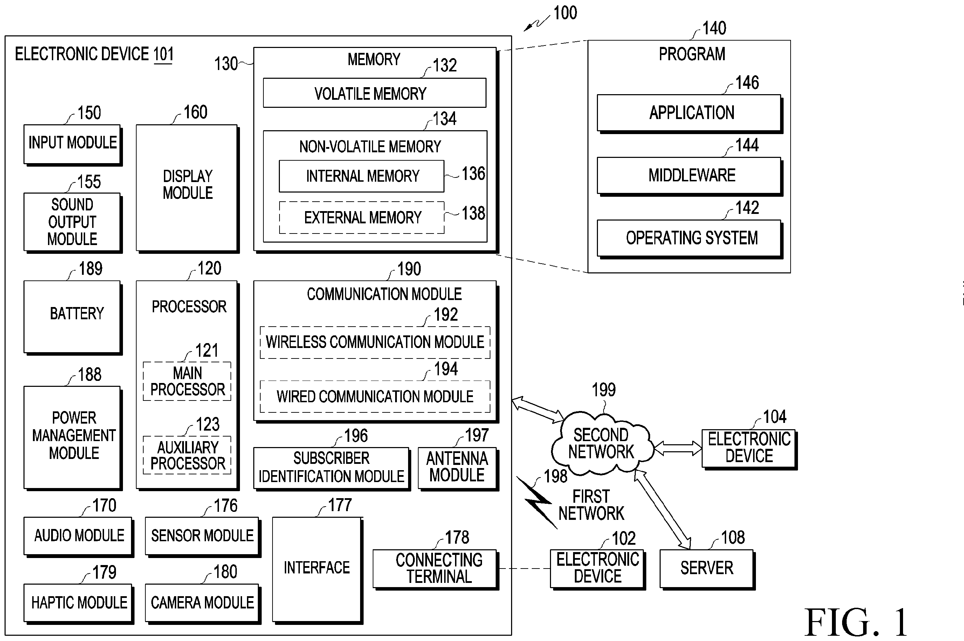

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," ***"coupled to," "connected with,"*** or "connected to "another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

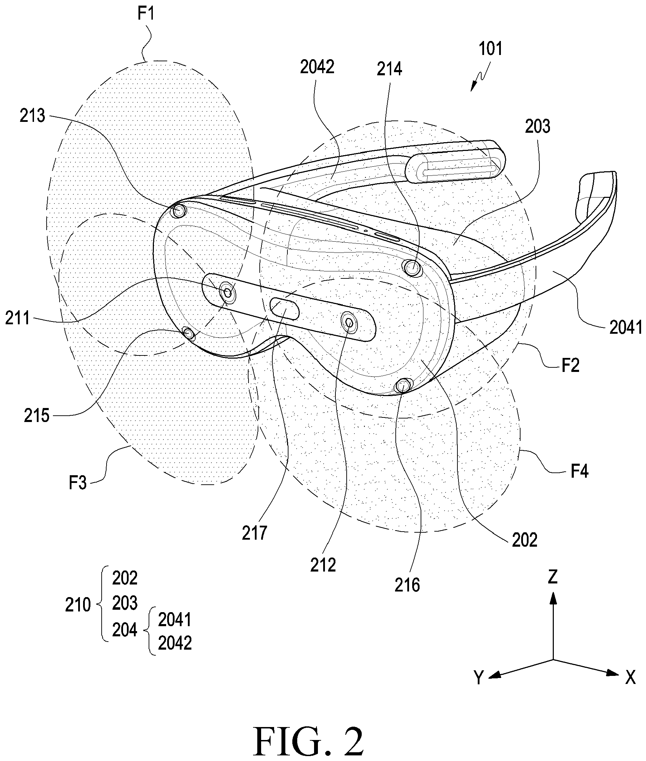

FIG. 2 is a front perspective view of a wearable electronic device, according to an embodiment of the disclosure.

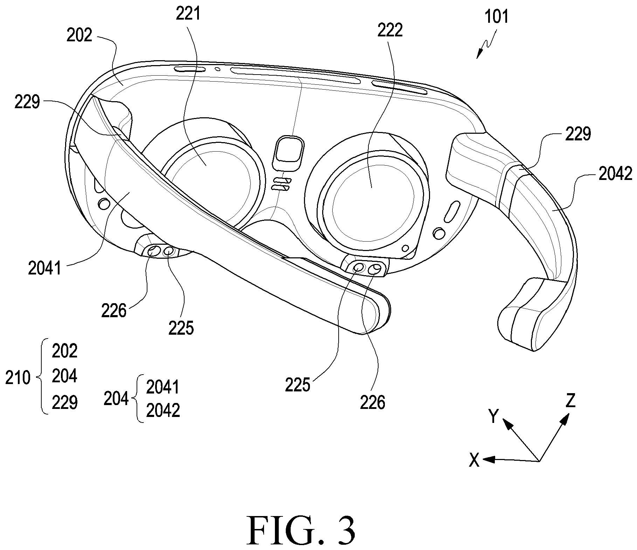

FIG. 3 is a rear perspective view of a wearable electronic device, according to an embodiment of the disclosure.

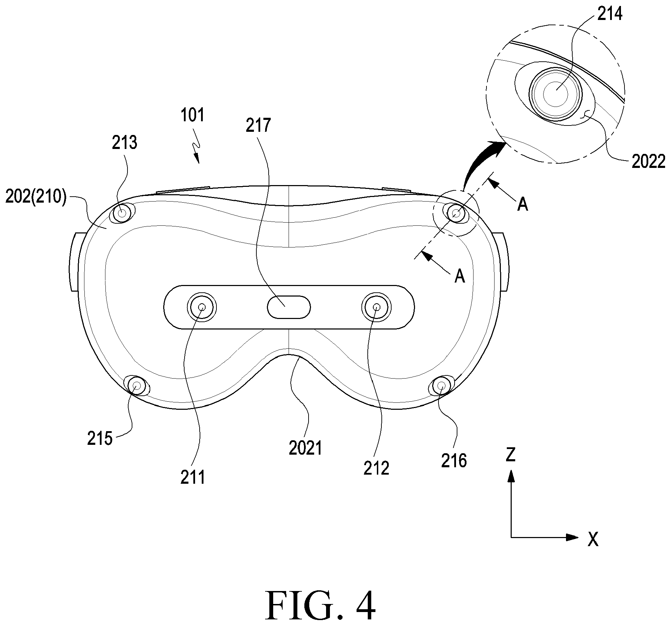

FIG. 4 is a front view of a wearable electronic device, according to an embodiment of the disclosure.

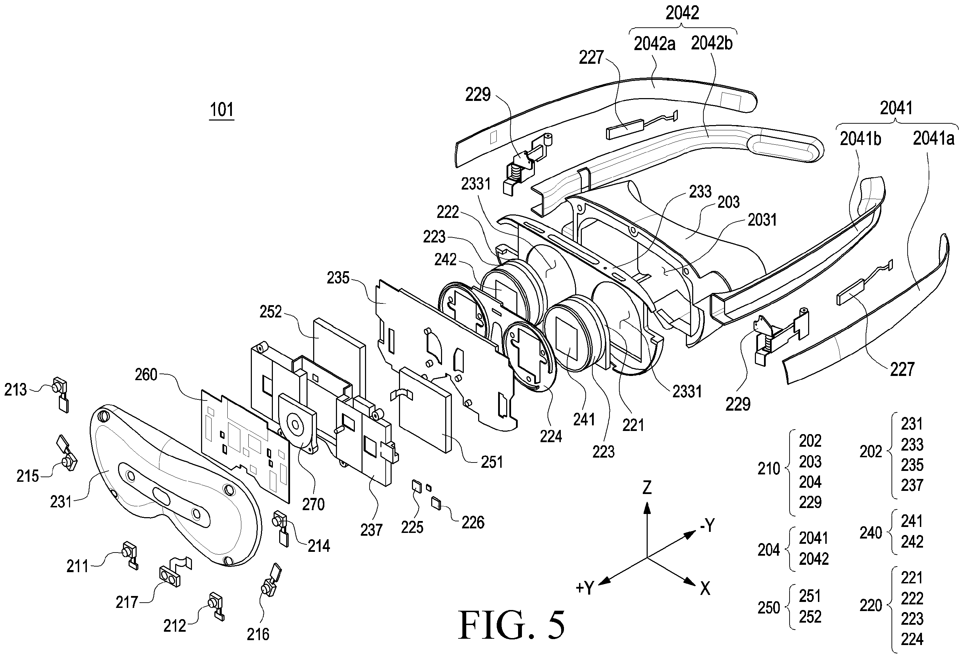

An embodiment of FIGS. 2 to 4 may be combined to an embodiment of FIG. 1 or embodiments of FIGS. 5 to 12.

The elements of a wearable electronic device 101 of FIG. 2 may be entirely or partially the same as the elements of the electronic device 101 of FIG. 1.

Referring to FIG. 2 to 4, the wearable electronic device 101 may include a housing 210.

According to an embodiment, the wearable electronic device 101 may be a body-worn device. For example, the wearable electronic device 101 may be smart glasses, a video see-through (VST) device, or a head mounting device capable of providing an image directly in front of a user's eyes. In the shown embodiment, the wearable electronic device 101 is shown as having the appearance of goggles, but the wearable electronic device 101 of the disclosure is not limited thereto and may have various types of appearances.

According to an embodiment, the wearable electronic device 101 may include a housing 210 forming an appearance of the wearable electronic device 101. According to an embodiment, the housing 210 may form an appearance of the wearable electronic device 101 and may provide a space in which parts of the wearable electronic device 101 may be arranged.

According to an embodiment, the housing 210 may include a first housing 202, a second housing 203, or at least one wearing member 204. In FIG. 3, for convenience of explanation, a state in which the second housing 203 is separated from the wearable electronic device 101 is shown.

According to an embodiment, the first housing 202 may provide a space in which parts of the wearable electronic device 101 are to be arranged. For example, the first housing 202 may be referred to as a cover housing or a body housing.

According to an embodiment, the first housing 202 may include a nose support (e.g., a nose support 2021 of FIG. 4) having at least a part formed concavely. The nose support 2021 may be located on the nose of a user, or supported by the nose of the user.

According to an embodiment, the wearable electronic device 101 may include a display module (e.g., a display module 240 of FIG. 5) disposed inside a first housing 202 and capable of outputting a visual image. The display module may output visual images to the user's left and right eyes through lenses 221 and 222 disposed on a rear surface of the first housing 202. For example, the lenses 221 and 222 may include a first lens 221 configured to correspond to the left eye of the user and a second lens 222 configured to correspond to the right eye of the user.

According to an embodiment, the wearable electronic device 101 may include VST camera modules 211 and 212, a plurality of camera modules 213, 214, 215, and 216, and/or an infrared camera module 217.

According to an embodiment, the camera modules 211 to 217 may be arranged on the first housing 202or may be exposed to the outside of the wearable electronic device 101 through the openings formed through the first housing 202.

According to an embodiment, the VST camera modules 211 and 212 may be camera modules for video see-through (VST). For example, the wearable electronic device 101 may display, on a display module, at least a part (or, an object processed based on at least a part and/or an object corresponding to at least a part) of an image related to an adjacent environment, captured via the VST camera modules 211 and 212, as at least a part of VST content. Accordingly the user may identify at least a part of the image related to an adjacent environment, captured via the VST camera modules 211 and 212. For example, VST content may be produced by mixing content for a VR environment and at least a part of the image captured via the VST camera modules 211 and 212. For example, the VST content may be produced by mixing content for the VR environment and a processing result (or, a corresponding object) of at least a part of the image captured via the VST camera modules 211 and 212. For example, the VST content may be produced based on at least a part of the image captured via the VST camera modules 211 and 212. For example, the VST content may be produced based on a processing result (or, a corresponding object) of at least a part of the image captured via the VST camera modules 211 and 212.

According to an embodiment, the wearable electronic device 101 may obtain a visual image for an object or environment in a direction which the user is looking at or the wearable electronic device 101 is facing (e.g., the Y-axis direction of FIGS. 2 to 3) by using a plurality of camera modules 213, 214, 215, and 216.

According to an embodiment, camera modules 213 and 214 may be arranged at a relatively upper portion of the first housing 202 (or, may be exposed through openings formed through the first housing 202). The camera modules 213 and 214 may capture an image corresponding to a field of view (FOV) based on at least one point of the first housing 202, for example, FOV F1 or F2 corresponding to the relatively upper side when the user wears the wearable electronic device 101. For example, referring to FIG. 2, the camera modules 213 and 214 may capture an image corresponding to a first FOV F1 and a second FOV F2. The image obtained by the camera modules 213 and 214 may be used, for example, by SLAM (simultaneous localization and mapping) and/or 6DoF (degrees of freedom), and/or may be used for recognition and/or tracking of a subject corresponding to the first FOV F1 and the second FOV F2. The image obtained by the camera modules 213 and 214 may also be used for head tracking.

According to an embodiment, camera modules 215 and 216 may be arranged at a relatively lower portion of the first housing 202 (or, may be exposed through openings formed through the first housing 202). The upper portion corresponding to the camera modules 213 and 214 and the lower portion corresponding to the camera modules 215 and 216 are defined when the user wears the wearable electronic device 101, and a portion relatively close to the ground is called a lower portion, and a portion relatively far from the ground is called an upper portion. It will be understood by a person skilled in the art that the above definition is only for convenience of explanation. The camera modules 215 and 216 may capture an image corresponding to an FOV based on at least one point of the first housing 202, for example, FOV F3 or F4 corresponding to the relatively lower side when the user wears the wearable electronic device 101. For example, referring to FIG. 3, the camera modules 215 and 216 may capture an image corresponding to a third FOV F3 and a fourth FOV F4. The image obtained by the camera modules 215 and 216 may be used for recognition and/or tracking of a subject corresponding to the third FOV F3 and the fourth FOV F4. For example, when the user wears the electronic device 101, the image obtained by the camera modules 215 and 216 may be used for recognition and/or tracking of a subject (e.g., the user's hand) disposed at a relatively lower side than a portion corresponding to the user's head, but is not limited thereto.

As shown in FIG. 2, the arrangement positions and/or arrangement directions of camera modules 213, 214, 215, and 216 may be determined so that there is an overlapping portion between the first FOV F1, the second FOV F2, the third FOV F3, and the fourth FOV F4, but this may be exemplary. The arrangement positions and/or arrangement directions of the camera modules 213, 214, 215, and 216 may be determined so that there is no overlap between the first FOV F1, the second FOV F2, the third FOV F3, and the fourth FOV F4, and there is no limit on whether the FOVs overlap each other.

According to an embodiment, the wearable electronic device 101 may perform recognition and/or tracking of a subject by using at least one image captured by the camera modules 213, 214, 215, and 216. The wearable electronic device 101 may perform an operation confirmed based on the result of the recognition and/or tracking and, for example, may provide a visual object to a position corresponding to the subject, but there is no limit to the operation. For example, when a virtual keyboard is provided by the wearable electronic device 101, designated keys on the virtual keyboard may be recognized based on the tracking result of the user's hand. An operation corresponding to the recognition and/or tracking result may be performed alone, for example, by the wearable electronic device 101, but this is exemplary, and the operation may be performed based on cooperation between the wearable electronic device 101 and an external electronic device (e.g., the external electronic device 102, the electronic device 104, and/or the server 108 of FIG. 1).

According to an embodiment, the camera modules 213, 214, 215, and 216 are for 3DoF or 6DoF head tracking, hand detection, hand tracking, and/or spatial recognition, and may be global shutter (GS) cameras, but there is no limit thereto. The camera modules may be implemented as rolling shutters (RS).

According to an embodiment, the infrared camera module 217 may include a time of flight (TOF) camera or a structured light camera. For example, an IR camera module 217 may operate as at least a part of a sensor module (a sensor module or a Lidar sensor) configured to detect the distance to a subject. According to an embodiment, the wearable electronic device 101 may further include a sensor module (e.g., a Lidar sensor). For example, the sensor module may include at least one among a vertical cavity surface emitting laser (VCSEL), an infrared sensor, and/or a photodiode. According to an embodiment, the IR camera module 217 may be used for determining a distance to an object (a subject), such as a TOF camera.

According to an embodiment, the wearable electronic device 101 may include a face tracking camera module 225. The face tracking camera module 225 may be used for detecting and tracking facial expressions of a user. For example, the face tracking camera module 225 may be exposed through an opening formed through the first housing 202.

According to an embodiment, the wearable electronic device 101may include a microphone module 226 (e.g., the input module 150 of FIG. 1). The microphone module 226 may convert sound into an electrical signal. The microphone module 226 may be used for obtaining voice information. In an embodiment, the microphone module 226 may be exposed through an opening formed through the first housing 202.

According to an embodiment, the second housing 203 may be a portion being in contact with the face of a user, when the user wears the wearable electronic device 101. In addition, the second housing 203 may be formed such that at least a part of the second housing 203 is curved to correspond to the user's forehead or cheekbones.

According to an embodiment, the second housing 203 may block external light from reaching the user's eyes by being in contact with the user's face, when the user wears the wearable electronic device 101. The second housing 203 may be referred to as a face cover or a cover housing. For example, the second housing 203 may be detachably coupled to the rear surface of the first housing 202.

According to an embodiment, the at least one wearing member 204 may extend from an end of the first housing 202, and may be supported by or positioned at the body (e.g., ears) of a user. According to an embodiment, the at least one wearing member 204 may include a first wearing member 2041 supported by the left ear of a user and a second wearing member 2042 supported by the right ear of the user.

According to an embodiment, the housing 210 may further include at least one hinge structure 229. According to an embodiment, the at least one wearing member 204 may be rotatably coupled to the first housing 202 via the at least one hinge structure 229. The at least one hinge structure 229 may be disposed between the first housing 202 and the at least one wearing member 204. In a state in which the wearable electronic device 101 is not worn by a user, the user may carry or store the wearing members 204 by folding the same so as to partially overlap the first housing 202.

According to an embodiment, the housing 210 (e.g., the first housing 202) may further openings 2022 formed at a portion adjacent an edge of the first housing 202.

According to an embodiment, the plurality of camera modules 213, 214, 215, and 216 may be arranged to be adjacent to an edge area of the first housing, respectively. For example, the plurality of camera modules 213, 214, 215, and 216 may be arranged at corners of the first housing 202 to secure a wide FOV. According to an embodiment, the plurality of camera modules 213, 214, 215, and 216 may be exposed to the outside of the wearable electronic device 101 through openings (e.g., openings 2022 in FIG. 4) formed at corners of the first housing 202. According to an embodiment, the plurality of camera modules 213, 214, 215, and 216 may be disposed in the openings 2022 formed at a portion of an edge of the first housing 202, and exposed to the outside of the wearable electronic device 101 through the openings 2022.

FIG. 5 is an exploded perspective view of a wearable electronic device, according to an embodiment of the disclosure.

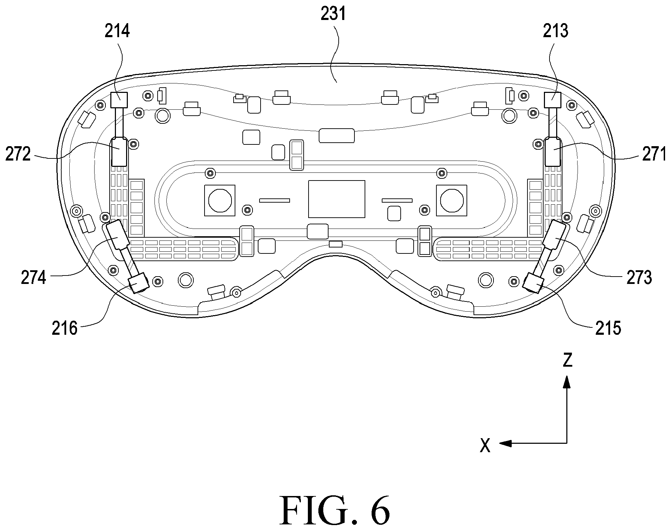

An embodiment of FIG. 5 may be combined with the embodiments of FIGS. 1 to 4 or the embodiments of FIGS. 6 to 12.

Referring to FIG. 5, a wearable electronic device 101may include a housing 210, camera modules 211, 212, 213, 214, 215, 216, 217, and 225, a lens assembly 220, a display module 240, a battery 250, a circuit board 260, a microphone module 226, and/or speaker modules 227.

The elements of the wearable electronic device 101, the housing 210, and/or the camera modules 211, 212, 213, 214, 215, 216, 217, and 225 of FIG. 5 may be entirely or partially the same as the elements of the wearable electronic device 101, the housing 210, and/or the camera modules 211, 212, 213, 214, 215, 216, 217, and 225 of FIGS 2 to 4.

According to an embodiment, the housing 210 of the wearable electronic device 101 may include a first housing 202 (e.g., the first housing 202 of FIGS. 2 to 4), a second housing 203 (e.g., the second housing 203 of FIGS. 2 to 4), at least one wearing member 204 (e.g., the at least one wearing member 204 of FIGS. 2 to 4), and/or at least one hinge structure 229 (e.g., the at least one hinge structure 229 of FIGS. 2 to 4).

According to an embodiment, the first housing 202 may include a front case 231, a rear case 233, a display support member 235, and/or a battery support member 237.

According to an embodiment, the appearance of the first housing 202 may be formed by coupling the front case 231 and the rear case 233. In addition, the internal space of the first housing 202 may be a space formed between the front case 231 and the rear case 233, in a state in which the front case 231 and the rear case 233 are coupled to each other. According to an embodiment, various electric parts may be arranged in the internal space of the first housing 202.

According to an embodiment, the front case 231 may be a housing disposed in the direction to which the user's face or the wearable electronic device 101 is directed (e.g., the +Y-axis direction of FIG. 5), when the user wears the wearable electronic device 101.

According to an embodiment, a plurality of openings may be formed through the front case 231. A plurality of camera modules 211, 212, 213, 214, 215, 216, and 217 may be arranged in the plurality of openings.

According to an embodiment, the rear case 233 may be a housing (e.g., a housing facing the -Y-axis direction of FIG. 5) facing the user's face, when the user wears the wearable electronic device 101.

According to an embodiment, a pair of first through-hole portions 2331 which may accommodate a pair of lens barrels 223 of the lens assembly 220 may be formed through the rear case 233. In addition, a pair of second through-hole portions 2031 may be formed at portions corresponding to the pair of first through-hole portions 2331 of the rear case 233, through the second housing 203 to which the rear case 233 is coupled.

According to an embodiment, the display support member 235 may be disposed between the front case 231 and the rear case 233. The display support member 235 may be referred to as a display bracket 235. In addition, the display support member 235 may be disposed between the rear case 233 and the battery support member 237.

According to an embodiment, the display support member 235 may support the display module 240 inside the first housing 202. For example, the display module 240 may be disposed on one surface of the display support member 235.

According to an embodiment, the battery support member 237 may be disposed between the front case 231 and the rear case 233. The battery support member 237 may be referred to as a battery bracket 237. In addition, the battery support member 237 may be disposed between the front case 231 and the display support member 235.

According to an embodiment, the battery support member 237 may provide a space in which the battery 250 may be accommodated inside the first housing 202. For example, the battery 250 may be inserted into a recess formed on the battery support member 237.

According to an embodiment, the at least one wearing member 204 may include a first wearing member 2041 worn on the left ear of a user and a second wearing member 2042 worn on the right ear of the user.

According to an embodiment, the first wearing member 2041 and the second wearing member 2042 may include outer side covers 2041a and 2042a and inner side covers 2041b and 2042b, respectively. For example, the inner side covers 2041b and 2042b, which are covers configured to face the user's body or to be in direct contact with the user's body, may be made of a material having low thermal conductivity, for example, synthetic resin. For example, the outer side covers 2041a and 2042a, which are covers configured such that the user's body does not come into contact with the covers or the covers face outward from the user's body, may include a material (e.g., a metallic material) which is at least partially thermally conductive, and may be coupled to the inner side covers 2041b and 2042b while facing each other. In an embodiment, the speaker modules 247 may be arranged in spaces formed by coupling the outer side covers 2041a and 2042aand the inner side covers 2041b and 2042b.

According to an embodiment, the first wearing member 2041 and the second wearing member 2042 may be unfolded or folded around the hinge structures 229, respectively. The at least one hinge structure 229 may be disposed in the first wearing member 2041 and the second wearing member 2042, respectively.

According to an embodiment, the lens assembly 220 may include a pair of lens barrels 223, lenses 221 and 222, and a lens bracket 224.

According to an embodiment, the pair of lens barrels 223 of the lens assembly 220 may be arranged in the pair of first through-hole portions 2331 of the rear case 233 and the pair of second through-hole portions 2031 of the second housing 203. In addition, the pair of lens barrels 223 may be fixed to the lens bracket 224. Accordingly, the first lens 221 (e.g., the first lens 221 of FIG. 3) and the second lens 222 (e.g., the second lens 222 of FIG. 3) arranged in the pair of lens barrels 223, respectively, may be arranged to face the eyes of a user.

According to an embodiment, the lens bracket 224 may be coupled to one surface (e.g., a surface facing the -Y-axis direction of FIG. 5) of the display support member 235.

According to an embodiment, the display module 240 (e.g., the display module 160 of FIG. 1) may provide information as a visual image to the outside (e.g., the eyes of a user) of the wearable electronic device 101 via the lens assembly 220. For example, the display module 240 may include, for example, a liquid crystal display (LCD), a digital mirror device (DMD), a liquid crystal on silicon (LCoS), an organic light emitting diode (LCoS), a light emitting diode (LED) on silicon (LEDoS), an organic light emitting diode (OLED), or a micro light emitting diode (micro LED). Although not shown, when the display module 240 is formed of one among a liquid crystal display, a digital mirror display, or a silicon liquid crystal display, the wearable electronic device 101 may include a light source for emitting light to a screen display area of the display module 240. In an embodiment, when the display module 240 is capable of producing light by itself, for example, when the display module is formed of one among an organic light emitting diode or a micro LED, the wearable electronic device 101 may provide a virtual image of good quality to a user even without a separate light source. In an embodiment, if the display module 240 is implemented as an organic light emitting diode or a micro LED, a light source is unnecessary, and thus the weight of the wearable electronic device 101 may be reduced.

According to an embodiment, the display module 240 may include a first display module 241 corresponding to the left eye of a user and the first lens 221, and a second display module 242 corresponding to the right eye of the user and the second lens 222.

According to an embodiment, the battery 250 (e.g., the battery 189 of FIG. 1) may provide a power source (or power) to parts of the wearable electronic device 101. According to an embodiment, the battery 250 may include a power management module (e.g., the power management module 188 of FIG. 1).

According to an embodiment, the battery 250 may include a first battery 251 and a second battery 252.

According to an embodiment, the first battery 251 and the second battery 252 may be electrically connected to the circuit board 260 via separate power transfer structures (e.g., conductive wires or FPCB), respectively.

According to an embodiment, the circuit board 260 (e.g., a PCB) may include parts for driving the wearable electronic device 101. For example, the circuit board 260 may include at least one integrated circuit chip, and at least one among a processor (e.g., the processor 120 of FIG. 1), a memory (e.g., the memory 130 of FIG. 1), a power management module (e.g., the power management module 188 of FIG. 1), or a communication module (e.g., the communication module 190 of FIG. 1) may be provided on the integrated circuit chip. According to an embodiment, the circuit board 260 may be disposed inside the first housing 202. For example, the circuit board 260 may be disposed between the front case 231 and the battery support member 237.

According to an embodiment, the circuit board 260 may be connected to a flexible printed circuit board (FPCB), and may transmit an electrical signal to electronic parts (e.g., the camera modules 211, 212, 213, 214, 215, 216, 217, and 225, the microphone module 226, the speaker modules 227, or the display module 240) of the electronic device via the flexible printed circuit board. According to an embodiment, the circuit board 260 may include a circuit board including an interposer.

According to an embodiment, the wearable electronic device 101 may further include a fan module 270. The fan module 270 may be disposed between the battery support member 237 and the circuit board 260. For example, the fan module 270 may produce air flow inside the first housing 202. When the internal temperature of the first housing 202 is higher than a designated temperature, or when the temperature of electric parts (e.g., the battery 250 or the circuit board 260) of the wearable electronic device 101 is higher than the designated temperature, the fan module 270 may produce air flow to lower the internal temperature of the first housing 202 or the temperature of the electric parts.

According to an embodiment, the face tracking camera module 225 may be disposed in an opening formed through the rear case 233.

According to an embodiment, the microphone module 226 (e.g., the input module 150 of FIG. 1) may be disposed in an opening formed through the rear case 233. The microphone module 226 may convert sound to an electric signal. For example, the wearable electronic device 101 may distinguish between voice information and ambient noise based on voice information and/or additional information (e.g., low-frequency vibrations of a user's skin and bones) obtained via the at least one microphone module 226. For example, the wearable electronic device 101 may clearly recognize a user's voice and perform a function (e.g., noise canceling) to reduce ambient noise.

According to an embodiment, the speaker modules 227 (e.g., the sound output module 155 of FIG. 1) may convert an electric signal to sound. At least a part of the speaker modules 227 according to an embodiment may be disposed in the wearing members 204 of the housing 210. According to an embodiment, the speaker modules 227 may be disposed inside the at least one wearing member 204 so as to be disposed adjacent to the user's ears.

The speaker modules 227 may be arranged in both the first wearing member 2041 and the second wearing member 2042, or the speaker module may be disposed in any one of the wearing members.

FIG. 6 is a rear view showing a front case and a plurality of camera modules, according to an embodiment of the disclosure.

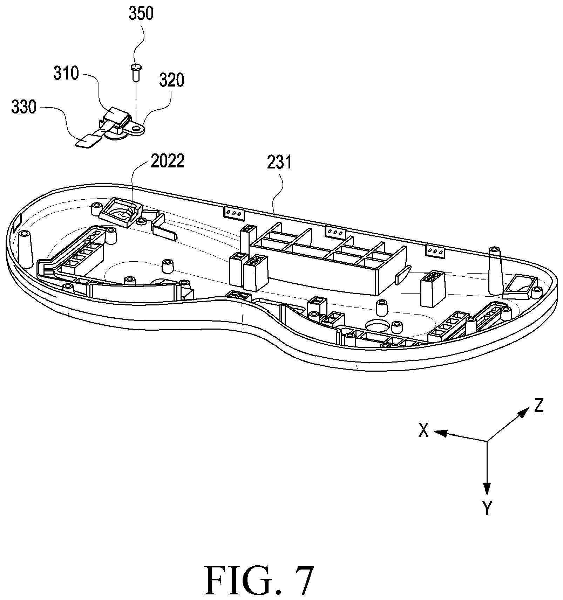

An embodiment of FIG. 6 may be combined with the embodiments of FIGS. 1 to 5 or the embodiments of FIGS. 7 to 12.

Referring to FIG. 6, the wearable electronic device 101 (e.g., the wearable electronic device 101 of FIGS. 2 to 5) may include a front case 231 (e.g., the front case 231 of FIG. 5), and/or a plurality of camera modules 213, 214, 215, and 216 (e.g., the plurality of camera modules 213, 214, 215, and 216 of FIG. 5).

The elements of the front case 231 and/or the plurality of camera modules 213, 214, 215, and 216 of FIG. 6 may be entirely or partially the same as the elements of the front case 231 and/or the plurality of camera modules 213, 214, 215, and 216 of FIG. 5.

According to an embodiment, the plurality of camera modules 213, 214, 215, and 216 may be referred to as an ultra-wide angle camera.

According to an embodiment, the plurality of camera modules 213, 214, 215, and 216 may be arranged outside the front case 231 to secure a wide FOV (e.g., FOV F1, F2, F3, and F4 of FIG. 2). For example, the plurality of camera modules 213, 214, 215, and 216 may be arranged at portions adj acent to the edge of the front case 231. In addition, the plurality of camera modules 213, 214, 215, and 216 may be arranged at corners of the front case 231 so that each camera module secures, or captures, an FOV for an area which is not visible to the user's eyes.

According to an embodiment, the plurality of camera modules 213, 214, 215, and 216 may be arranged in openings (e.g., the openings 2022 of FIG. 4) formed through the front case 231. In addition, the plurality of camera modules 213, 214, 215, and 216 may be arranged to be exposed to the outside (or the outside of the front case 231) of the wearable electronic device 101, so as to secure a wide FOV.

According to an embodiment, the plurality of camera modules 213, 214, 215, and 216 may be electrically connected to a circuit board (e.g., the circuit board 260 of FIG. 5) via a plurality of flexible printed circuit boards 271, 272, 273, and 274, respectively.

FIG. 7 is a perspective view showing a state before a front case and a camera module are coupled to each other, according to an embodiment of the disclosure.

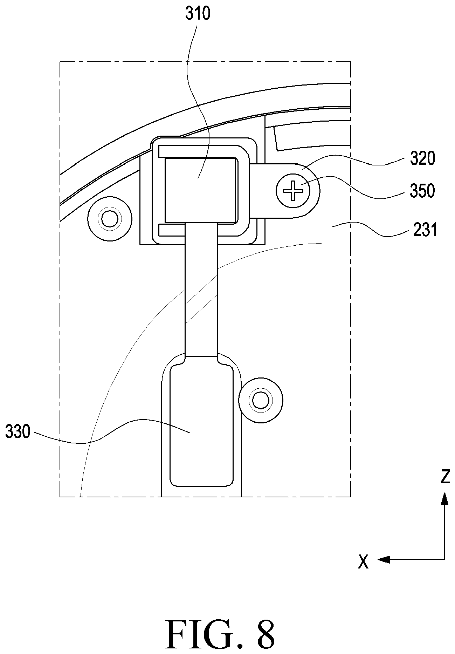

FIG. 8 is a plan view showing a state in which a front case and a camera module are coupled to each other, according to an embodiment of the present disclosure.

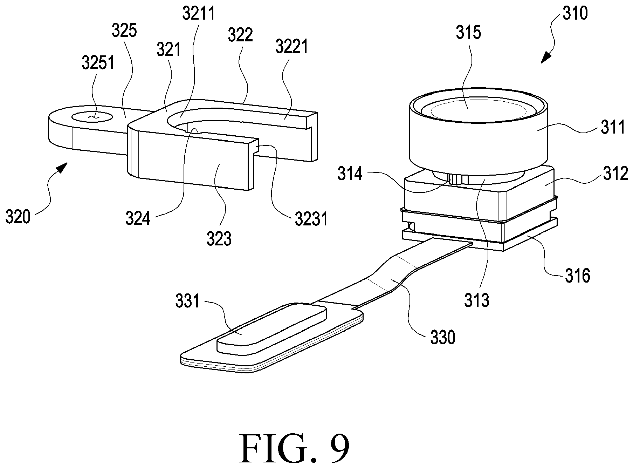

FIG. 9 is a perspective view showing a camera module, a camera support member, and a flexible printed circuit board, according to an embodiment of the disclosure.

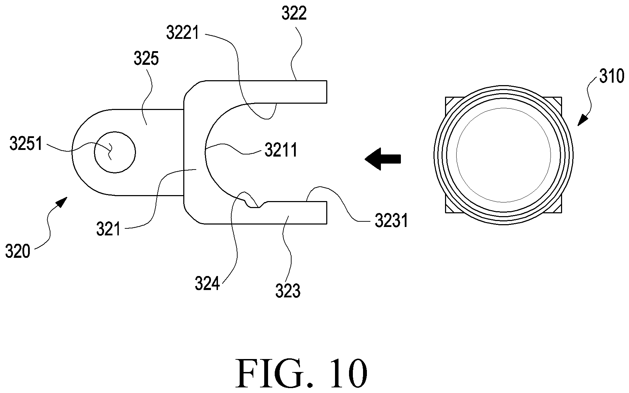

FIG. 10 is a plan view showing a camera module and a camera support member, according to an embodiment of the disclosure.

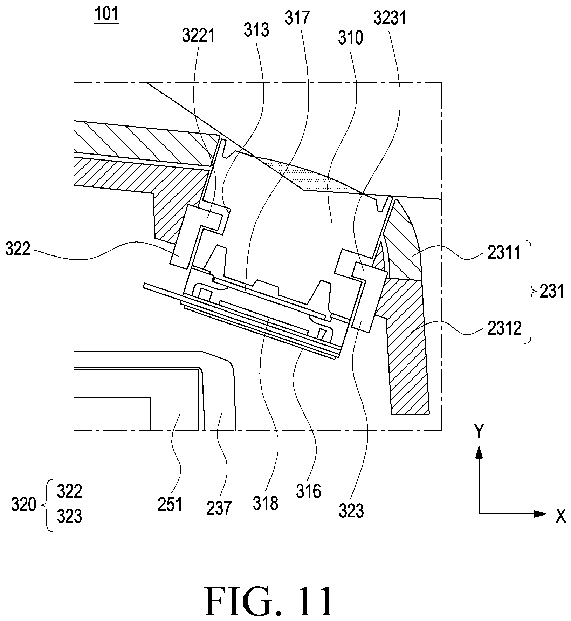

Embodiments of FIGS. 7 to 10 may be combined with the embodiments of FIGS. 1 to 6, or the embodiments of FIGS. 11 to 12.

Referring to FIGS. 7 to 10, a wearable electronic device 101 (e.g., the wearable electronic device 101 of FIGS. 2 to 6) may include a front case 231, a camera module 310, a camera support member 320, and a flexible printed circuit board 330.

The elements of the front case 231 of FIGS. 7 to 10 may be entirely or partially the same as the elements of the front case 231 of FIGS. 5 to 6. The elements of the camera module 310 or the flexible printed circuit board 330 of FIGS. 7 to 10 may be entirely or partially the same as the elements of the camera modules 213, 214, 215, and 216 or the flexible printed circuit boards 271, 272, 273, and 274 of FIG. 6.

Hereinafter, the camera module 310 and the flexible printed circuit board 330 described as an example of FIGS. 7 to 10 have a configuration having positions corresponding to the camera module 214 and the flexible printed circuit board 272 of FIG. 6, but the description thereof may be applied and understood in the same or similar manner to the camera modules 213, 215, and 216 and the flexible printed circuit boards 271, 273, and 274 of FIG. 6.

According to an embodiment, the front case 231 may include at least one opening 2022 (e.g., the openings 2022 of FIG. 4). At least one camera module 310 may be disposed in the at least one opening 2022.

According to an embodiment, the at least one camera module 310 (e.g., an ultra-wide angle camera) may be exposed to the outside (e.g., the Y-axis direction) of the wearable electronic device via the openings 2022. For example, the camera lens (e.g., the lens 315 of FIG. 9) of the camera module 310 may be exposed to the outside of the wearable electronic device.

According to an embodiment, the camera module 310 may be electrically connected to a circuit board (e.g., the circuit board 260 of FIG. 5) of the wearable electronic device via at least one flexible printed circuit board 330.

According to an embodiment, the wearable electronic device may further include at least one camera support member 320 for fixing the camera module 310. The camera support member 320 may be referred to as a camera bracket.

According to an embodiment, the camera support member 320 may fix the position of the camera module 310 to prevent the camera module 310 disposed in the opening 2022 of the front case 231 from escaping out of the front case 231. For example, the camera support member may be coupled to the camera module 310 to prevent the camera module 310 disposed in the opening 2022 from escaping from the opening 2022 to the outer side (e.g., the outside of the wearable electronic device) of the front case 231.

According to an embodiment, the camera support member 320 may be coupled to the front case 231 via a coupling member 350 (e.g., a bolt, rivet, adhesive, double-sided tape, clip, or pin).

Referring to FIG. 9, the camera module 310 may include camera housings 311 and 312, at least one first groove 313, at least one protrusion member 314, and a substrate 316. The camera housings 311 and 312 may be configured as a single camera housing. The single camera housing may comprise the first groove 313. The first groove 313 makes it possible to easily attach the camera housing or the camera housings 311 and 312 to the housing of the electronic device 101, for example to the front case 231. At the same time, installation space can be saved. Further advantages include that design shape constraints may be minimised, and that the amount of interference of the camera module with an ultra-wide angle of view of the camera may also be minimised. Camera performance may be optimised by expanding the coverage area through peripheral mounting. Also, a reduced mounting thickness may be achieved by eliminating the need for a bracket shape with comparatively large dimensions.

According to an embodiment, the camera housings 311 and 312 may include a barrel housing 311 in which a camera lens 315 is disposed and a holder housing 312 coupled to one surface of the substrate 316.

According to an embodiment, the appearance of the camera module 310 may be formed by the coupling of the barrel housing 311 and the holder housing 312.

According to an embodiment, at least one camera lens 315 may be disposed inside the barrel housing 311. The barrel housing 311 may be formed in a cylindrical shape, but is not limited thereto. According to an embodiment, the barrel housing 311 may be formed of a metallic material and/or a non-metallic material. According to an embodiment, the barrel housing 311 of a metallic material may be coated with a non-metallic material to prevent diffused reflection of light.

According to an embodiment, at least a part of the barrel housing 311 may be exposed to the outside of the wearable electronic device via the opening 2022 of the front case 231, and accordingly, the camera lens 315 may be exposed to the outside of the wearable electronic device.

According to an embodiment, the camera lens 315 may be disposed inside the barrel housing 311. For example, the camera lens 315 may collect light reflected from an external object to an image sensor (e.g., the image sensor 318 of FIGS. 11 to 12).

According to an embodiment, the camera lens 315 may be provided as a single lens or provided by overlapping a plurality of lenses. As an example, the camera lens 315 may be formed of glass, quartz, or synthetic resin, but is not limited thereto and may be formed of various materials.

According to an embodiment, at least a part of the barrel housing 311 may be accommodated in the holder housing 312. For example, the barrel housing 311 may be coupled to the holder housing 312.

According to an embodiment, a filter (e.g., the filter 317 of FIGS. 11 to 12) and an image sensor (e.g., the image sensor 318 of FIGS. 11 to 12) may be arranged inside the holder housing 312. The filter may include an infrared filter (IR filter) which filters the light collected through the camera lens 315 into a wavelength of a required region band. For example, the filter may be configured to block a wavelength band in the infrared region, which is noise in image processing, and allow only light in the visible region to reach the image sensor. The image sensor may be disposed on one surface of the substrate 316. The image sensor may convert the light incident through the camera lens 315 into an electric signal. The image sensor may include any one among a complementary metal-oxide semiconductor (CMOS) and a charge coupled device (CCD), is not limited thereto, and may be provided in various manners. The image sensor may be disposed on the same optical axis as the optical axis of the camera lens 315.

According to an embodiment, the substrate 316 (e.g., a PCB) may be coupled to a lower end of the holder housing 312. The substrate 316 may be electrically connected to a circuit board (e.g., the circuit board 260 of FIG. 5) via the flexible printed circuit board 330.

According to an embodiment, the at least one first groove 313 may be a concave portion formed on at least a portion of the outer peripheral surfaces of the camera housings 311 and 312. The first groove 313 may be annular or ring-shaped and encompass the entire circumference of the camera housing 311 and/or the camera housing 312. For example, the first groove 313 may be defined as a gap formed in the coupling structure of the barrel housing 311 and the holder housing 312. According to an embodiment, the barrel housing 311 may include a first diameter portion having a relatively large diameter and a second diameter portion having a relatively small diameter. The second diameter portion of the barrel housing 311 may be a portion to be inserted into the holder housing 312. The barrel housing may be defined such that at least a part of the second diameter portion of the barrel housing 311 is inserted into the holder housing 312 and the rest of the second diameter portion of the barrel housing 311 is not inserted into the holder housing 312 to form the first groove 313.

According to an embodiment, the at least one protrusion member 314 may be disposed on at least a portion of the at least one first groove 313. For example, the at least one protrusion member 314 may be defined as a portion protruding from the at least one first groove 313. According to an embodiment, the at least one protrusion member 314 may be formed of a synthetic resin material (e.g., a mold material), but is not limited thereto.

According to an embodiment, the flexible printed circuit board 330 may be electrically connected to the substrate 316. In addition, the flexible printed circuit board 330 may include a connector 331 configured to be connected to a circuit board (e.g., the circuit board 260 of FIG. 5) of the wearable electronic device.

According to an embodiment, the camera support member 320 may include body portions 321, 322, and 323, at least one second groove 324, or a coupling portion 325.

According to an embodiment, the body portions 321, 322, and 323 may cover at least a part of the camera module 310. For example, the body portions 321, 322, and 323 may be formed in a "U" shape to surround at least a part of a side surface of the camera module 310. The body portions 321, 322 and 323 may, for example, substantially cover three sides of camera housing 312, if camera housing 312 has a cuboid base shape, or may substantially cover about 270° of a circumference of camera housing 312, if camera housing 312 has a cylindrical base shape. In this way, the camera housing 312 can be held securely while leaving an opening for insertion of the camera housing 312. In addition, the body portions 321, 322, and 323 may be defined to have a recess structure which is capable of accommodating at least a part of the camera module 310.

According to an embodiment, the body portions 321, 322, and 323 may include a first side wall 321, a second side wall 322 extending from one end of the first side wall 321, and a third side wall 323 extending from the other end of the first side wall 321 in the same direction as the second side wall 322.

According to an embodiment, the second side wall 322 and the third side wall 323 may be arranged to be parallel to each other.

According to an embodiment, the first side wall 321, the second side wall 322, and the third side wall 323 may be arranged to be similar to a "U" shape. According to an embodiment, the first side wall 321, the second side wall 322, and the third side wall 323 may be arranged to surround at least a part of the camera housings 311 and 312 of the camera module 310.

According to an embodiment, the first side wall 321 may include a first protrusion portion 3211 protruding more toward the camera module 310 than other portions of the first side wall 321. For example, the first side wall 321 may be defined to have a structure stepped by the first protrusion portion 3211. According to an embodiment, the second side wall 322 may include a second protrusion portion 3221 protruding more toward the third side wall 323 than other portions of the second side wall 322. For example, the second side wall 322 may be defined to have a structure stepped by the third protrusion portion 3231. In addition, the third side wall 323 may include a third protrusion portion 3231 protruding more toward the second side wall 322 than other portions of the third side wall 323. For example, the third side wall 323 may be defined to have a structure stepped by the third protrusion portion 3231. The protrusion portions 3211, 3221 and 3231 may be formed continuous or sectional along the length of the side walls 321, 322, and 323 respectively.

According to an embodiment, in a state in which the camera module 310 and the camera support member 320 are assembled with each other (or a coupled state), the protrusion portions 3211, 3221, and 3231 may be inserted into the first groove 313 of the camera module 310. According to an embodiment, the protrusion portions 3211, 3221, and 3231 may provide a fixing structure for the camera module 310 to prevent the camera module 310 from escaping to the outside through the openings 2022. The protrusion portions 3211, 3221, and 3231 may each be arranged at an edge or close to an edge of the body portions 321, 322 and 323, respectively, which is oriented towards an outer surface of the electronic device 101. The protrusion portions 3211, 3221, and 3231 may each be arranged at an edge or close to an edge of the body portions 321, 322 and 323, respectively, which is closer to barrel housing 311 of the camera module 310 than to a holder housing 312 of the camera module 310.

According to an embodiment, the camera support member 320 may include at least one second groove 324 into which the protrusion member 314 of the camera module 310 is configured to be inserted. The second groove 324 may be a portion formed to be recessed on at least a part of the third protrusion portion 3231.

According to an embodiment, in a state in which the camera module 310 and the camera support member 320 are assembled (or a coupled state) with each other, the protrusion member 314 may be disposed on the second groove 324. The protrusion member 314 and the second groove 324 may form an engagement structure. Even if an external impact is applied to the wearable electronic device, the camera module 310 may not rotate on the camera support member 320 due to the engagement structure of the protrusion member 314 and the second groove 324. Accordingly, the camera module 310 may not be rotated with reference to the optical axis of the camera lens 315, and thus the connector 331 of the flexible printed circuit board 330 connected to the camera module 310 may be prevented from escaping from the circuit board (e.g., the circuit board 260 of FIG. 5).

The numbers and positions of the protrusion member 314 and the second groove 324 may be variously modified. For example, there may be a second, third, and fourth protrusion member. Correspondingly, there may be a third, fourth, and fifth groove. In other words, the camera support member may comprise, for example, two, three or four (second) grooves, and the camera module 310 (or the first groove 313) may, for example, comprise two, three or four protrusion members.

According to an embodiment, the camera support member 320 may further include a coupling portion 325. According to an embodiment, the coupling portion 325 may be a portion extending from the first side wall 321. The coupling portion 325 may include a coupling hole 3251 through which the coupling member 350 (e.g., the coupling member 350 of FIGS. 7 to 8) is disposed. The camera support member 320 may be fixed to the front case 231 through the coupling hole 3251 (or the coupling portion 325) by the coupling member 350.

According to an embodiment, the camera support member 320 may be provided in a shape having one open side due to a coupling structure of the first side wall 321, the second side wall 322, and the third side wall 323.

Referring to FIG. 10, the camera module 310 may slide to an open portion of the camera support member 320 at a position of one side of the camera support member 320 to be assembled to the camera support member 320. The protrusion portions 3211, 3221, and 3231 may be inserted into the first groove 313 of the camera module 310. In addition, the protrusion member 314 may be inserted into the second groove 324 of the camera support member 320.

FIG. 11 is a cross-sectional view of the wearable electronic device, taken along line A-A of FIG. 4, according to an embodiment of the disclosure.

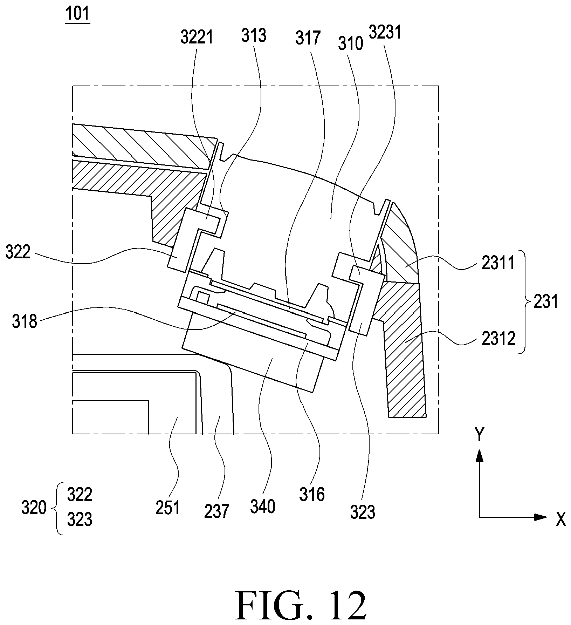

FIG. 12 is a cross-sectional view of the wearable electronic device, taken along line A-A of FIG. 4, according to an embodiment of the disclosure.

Embodiments of FIGS. 11 to 12 may be combined with the embodiments of FIGS. 1 to 10.

Referring to FIGS. 11 to 12, a wearable electronic device 101(e.g., the wearable electronic device 101 of FIGS. 2 to 5) may include a front case 231, a battery support member 237, a first battery 251, a camera module 310, and a camera support member 320.

The elements of the front case 231, the battery support member 237, or the first battery 251 of FIGS. 11 to 12 may be entirely or partially the same as the elements of the front case 231, the battery support member 237, or the first battery 251 of FIG. 5. The elements of the camera module 310 or the camera support member 320 of FIGS 11 to 12 may be entirely or partially the same as the elements of the camera module 310 or the camera support member 320 of FIGS. 7 to 10.

According to an embodiment, the front case 231 may include a cover case 2311 and an inner case 2312. For example, the inner case 2312 may be formed of a metallic material to improve the rigidity of the front case 231. In addition, the cover case 2311 may be coupled to the inner case 2312. For example, the cover case 2311 may form an outer portion of the front case 231. The cover case 2311 may be formed of a non-metallic material to reduce the weight of the front case 231.

According to an embodiment, the camera module 310 may be disposed in an opening (e.g., the opening 2022 of FIG. 7) of the front case 231. According to an embodiment, the lens (e.g., the lens 315 of FIG. 9) and the barrel housing (e.g., the barrel housing 311 of FIG. 9) of the camera module 310 may be arranged in the opening, and thus the camera module 310 may ensure a wide FOV (e.g., FOV F1, F2, F3, and F4 of FIG. 2).

According to an embodiment, the protrusion portions 3221 and 3231 (e.g., the protrusion portions 3211, 3221, and 3231 of FIGS. 9 to 10) of the camera support member 320 may be inserted into the first groove 313 (e.g., the first groove 313 of FIG. 9) of the camera module 310.

According to an embodiment, the camera module 310 may further include a filter 317 (e.g., an IR filter) and an image sensor 318 arranged inside a holder housing (e.g., the holder housing 312 of FIG. 9). The image sensor 318 may be disposed on the substrate 316.

According to an embodiment, the camera support member 320 may include a first side wall (e.g., the first side wall 321 of FIGS. 9 to 10), a second side wall 322 (e.g., the second side wall 322 of FIGS. 9 to 10) and a third side wall 323 (e.g., the third side wall 323 of FIGS. 9 to 10). The camera support member 320 may be fixed to the front case 231. One of the first side wall 321, the second side wall 322 and the third side wall 323, or portions thereof, may be omitted.

According to an embodiment, the camera module 310 may be fixed to the camera support member 320 to prevent the front case 231 from escaping out of the front case 231. For example, the protrusion portions 3221 and 3231 may be inserted into the first groove 313 to prevent the camera module 310 from escaping.

For example, if the camera support member is not provided, a flange shape may be applied to the camera module to prevent the escaping of the camera module. In order to form the flange shape and the engagement structure of the camera module, a portion dug out as much as the flange shape may be required in the front case. Accordingly, the dug-out portion may be applied to at least a part of the front case, and thus the rigidity of the front case may be reduced.

The camera module 310 of the disclosure may be fixed to the front case 231 via the camera support member 320 to fix the position of the camera module 310. In addition, the escaping of the camera module 310 may be prevented without a dug-out portion in the front case 231, and thus, compared to the case where the front case has a dug-out portion, the rigidity of the front case 231 may be relatively improved.

Referring to FIG. 12, the wearable electronic device 101 may further include a buffer member 340. The buffer member 340 may be disposed between the substrate 316 of the camera module 310 and the battery support member 237. The buffer member 340 may be formed of at least one among a sponge material or a rubber material.

The buffer member 340 may block the camera module 310 from sliding toward the inner side of the front case 231, when an external impact is applied to the wearable electronic device 101. In addition, the buffer member 340 may absorb the external impact to alleviate the external impact applied to the first battery 251.

A wearable electronic device such as a head-mounted device is increasingly becoming miniaturized and lightweight so as to increase portability and convenience of a user. In addition, in the wearable electronic device, a plurality of camera modules may be provided to photograph an area which is not visible to a user.

In general, the camera modules may be arranged to be exposed to the outside of a housing of a wearable electronic device in order to secure a wide FOV. However, in order to prevent escaping of the camera modules, a flange structure may be applied to the camera modules, and a dug-out portion may be formed in the housing to form the flange structure and an engagement structure. If at least a part of the housing is dug out to provide an engagement structure for the camera modules, the rigidity of the housing may decrease.

According to an embodiment of the disclosure, a wearable electronic device which is able to prevent and/or reduce the escaping of a camera module and improve the rigidity of the housing may be provided.

The problems to be solved in the disclosure are not limited to the above-mentioned problems, and may be variously confirmed without departing from the spirit and scope of the disclosure.

A wearable electronic device according to an embodiment of the disclosure may prevent and/or reduce the escaping of a camera module via a coupling structure of a camera support member and the camera module.

In a wearable electronic device according to an embodiment of the disclosure, a camera module may be exposed to the outside of a housing to ensure a wide field of view (FOV).

Effects obtainable in the disclosure are not limited to the above-mentioned effects, and other effects which have not been mentioned may be clearly understood from the description below by those skilled in the art to which the disclosure belongs.

According to an embodiment of the disclosure, a wearable electronic device 101 may include a housing 202 or 210, a display module 240, a battery 250, a camera module 310, or a camera support member 320. The housing may include an opening 2022. The display module 240 may be disposed in the housing. The housing may be configured to output a visual image. The battery may be disposed in the housing. The camera module 310 may be disposed in the opening. The camera module may include a first groove 313. The first groove may be formed to be recessed on at least a part of a side surface of the camera module. The camera support member may be configured to fix the camera module to the housing. The camera support member may include body portions 321, 322, and 323, or at least one protrusion portion 3211, 3221, and 3231. The body portions formed to surround at least a part of the camera module. The at least one protrusion portion may be protruded from at least a part of the body portions to be inserted into the first groove.

According to an embodiment, the camera support member may further include a second groove 324. The second groove may be formed to be recessed on the at least one protrusion portion. The camera module may further include a protrusion member 314. The protrusion member may be formed to protrude from the first groove and configured to be inserted into the second groove.

According to an embodiment, the opening may be formed at a portion adjacent to an edge of the housing.

According to an embodiment, the opening may be formed at a portion adjacent to a corner of the housing.

According to an embodiment, the body portions may include a first side wall 321, a second side wall 322, or a third side wall 323. The second side wall may be extending from one end of the first side wall. The third side wall 323 may be extending from the other end of the first side wall. The third side wall may be disposed to be parallel to the second side wall.

According to an embodiment, the at least one protrusion portion may be formed to protrude toward the camera module from at least one among the first side wall, the second side wall, and the third side wall.

According to an embodiment, the at least one protrusion portion may include a first protrusion portion 3211, a second protrusion portion 3221, or a third protrusion portion 3231. The first protrusion portion may be formed on the first side wall. The second protrusion portion 3221 may be formed on the second side wall. The third protrusion portion 3231 may be formed on the third side wall.

According to an embodiment, the camera support member may further include a coupling portion 325. The coupling portion may be extending from the first side wall. The coupling portion may be fixed to the housing.

According to an embodiment, the wearable electronic device may further include a circuit board 260, or a flexible printed circuit board 330. The circuit board 260 may be disposed in the housing. The flexible printed circuit board may be configured to electrically connect the circuit board and the camera module.

According to an embodiment, the wearable electronic device may further include a battery support member 237. The battery support member may be disposed in the housing and accommodating the battery.

According to an embodiment, the wearable electronic device may further include a buffer member 340. The buffer member may be disposed between the camera module and the battery support member.

According to an embodiment, the buffer member may be formed of at least one among a rubber material or a sponge material.

According to an embodiment, the display module may include a first display module 241, or a second display module 242. The first display module may be disposed to correspond to the left eye of a user. The second display module 242 may disposed to correspond to the right eye of the user.

According to an embodiment, the wearable electronic device may further include at least one wearing member 204. The at least one wearing member may be configured to be coupled to the housing.

According to an embodiment, a lens 315 of the camera module may be exposed to the outside of the wearable electronic device through the opening.

According to an embodiment of the disclosure, a wearable electronic device 101 may include a housing 202 or 210, at least one wearing member 204, a display module 240, a battery 250, a camera module 310, or a camera support member 320. The housing may include an opening 2022. The opening may be formed at a portion adjacent to an edge of the housing. The at least one wearing member may be foldably connected to the housing. The display module may be disposed in the housing. The display module may be configured to output a visual image. The battery may be disposed in the housing. The camera module may be disposed in the opening. The camera module may include a first groove 313. The first groove may be formed to be recessed on at least a part of a side surface of the camera module. The camera support member may be configured to fix the camera module to the housing. The camera support member may include body portions 321, 322, and 323, or at least one protrusion portion 32211, 3221, and 3231. The body portions may be formed to surround at least a part of the camera module. The at least one protrusion portion 3211, 3221, and 3231 may be protruding from at least a part of the body portions to be inserted into the first groove.

According to an embodiment, the camera module may include a camera lens 315, camera housings 311 and 312, a substrate 316, a filter 317, or an image sensor 318. The camera housings may be accommodating the camera lens. The camera housing may include the first groove. The substrate may be coupled to the camera housing. The filter may be disposed in the camera housing. The image sensor 318 may be disposed on the substrate and disposed in the camera housing.

According to an embodiment, the wearable electronic device may further include a circuit board 260, or a flexible printed circuit board 330. The circuit board may be disposed in the housing. The flexible printed circuit board 330 may be configured to electrically connect the substrate of the camera module and the circuit board.

According to an embodiment, the body portions may include a first side wall 321, a second side wall 322, or a third side wall 323. The second side wall 322 may be extending from one end of the first side wall. The third side wall 323 may be extending from the other end of the first side wall. The third side wall may be disposed to be parallel to the second side wall. The at least one protrusion portion may include a first protrusion portion 3211, a second protrusion portion 3221, or a third protrusion portion 3231. The first protrusion portion may be formed on the first side wall. The second protrusion portion may be formed on the second side wall. The third protrusion portion may be formed on the third side wall.

According to an embodiment, the camera support member may further include a second groove. The second groove may be formed to be recessed on the at least one protrusion portion. The camera module may further include a protrusion member 314. The protrusion member 314 may be formed to protrude from the first groove. The protrusion member may be configured to be inserted into the second groove.

According to an embodiment, the at least one protrusion portion may comprise a first protrusion portion 3211 formed on the first side wall.

According to an embodiment, the at least one protrusion portion may comprise a second protrusion portion 3221 formed on the second side wall.

According to an embodiment, the at least one protrusion portion may comprise a third protrusion portion 3231 formed on the third side wall.

In the detailed description of the disclosure, specific embodiments have been described, but it will be obvious to those skilled in the art that various modifications are possible without departing from the scope of the disclosure.

## Claims

1. A wearable electronic device (101) comprising:
a housing (202, 210) including an opening (2022);
a display module (240) disposed in the housing and configured to output a visual image;
a battery (250) disposed in the housing;
a camera module(310) disposed in the opening and including a first groove(313) formed to be recessed on at least a part of a side surface of the camera module; and
a camera support member(320) configured to fix the camera module to the housing,
wherein the camera support member comprises:
body portions (321, 322, and 323) formed to surround at least a part of the camera module; and
at least one protrusion portion (3211, 3221, and 3231) protruding from at least a part of the body portions to be inserted into the first groove.

2. The wearable electronic device of claim 1, wherein the camera support member further comprises a second groove (324) formed to be recessed on the at least one protrusion portion, and
wherein the camera module further comprises a protrusion member 314 formed to protrude from the first groove and configured to be inserted into the second groove.

3. The wearable electronic device of any one of claims 1 to 2, wherein the opening is formed at a portion adjacent to an edge of the housing.

4. The wearable electronic device of any one of claims 1 to 3, wherein the opening is formed at a portion adjacent to a corner of the housing.

5. The wearable electronic device of any one of claims 1 to 4, wherein the body portions comprise:
a first side wall (321);
a second side wall (322) extending from one end of the first side wall; and
a third side wall (323) extending from the other end of the first side wall and disposed to be parallel to the second side wall.

6. The wearable electronic device of any one of claims 1 to 5, wherein the at least one protrusion portion is formed to protrude toward the camera module from at least one among the first side wall, the second side wall, and the third side wall.

7. The wearable electronic device of any one of claims 1 to 6, wherein the at least one protrusion portion comprises:
a first protrusion portion (3211) formed on the first side wall;
a second protrusion portion (3221) formed on the second side wall; and
a third protrusion portion (3231) formed on the third side wall.

8. The wearable electronic device of any one of claims 1 to 7, wherein the camera support member further comprises a coupling portion (325) extending from the first side wall and fixed to the housing.

9. The wearable electronic device of any one of claims 1 to 8, further comprising a buffer member (340) disposed between the camera module and the battery support member.

10. The wearable electronic device of any one of claims 1 to 9, wherein the buffer member is formed of at least one among a rubber material or a sponge material.

11. The wearable electronic device of any one of claims 1 to 10, wherein a lens (315) of the camera module is exposed to the outside of the wearable electronic device through the opening.

12. The wearable electronic device of any one of claims 1 to 11, wherein the opening (2022) is formed at a portion adjacent to an edge of the housing; and wherein the wearable electronic device further comprises
at least one wearing member (204) foldably connected to the housing.

13. The wearable electronic device of any one of claims 1 to 12, wherein the camera module comprises:
a camera lens 315;
camera housings (311 and 312) accommodating the camera lens and including the first groove formed thereon;
a substrate (316) coupled to the camera housing;
a filter (317) disposed in the camera housing; and
an image sensor (318) disposed on the substrate and disposed in the camera housing.

14. The wearable electronic device of any one of claims 1 to 13, further comprising:
a circuit board (260) disposed in the housing; and
a flexible printed circuit board (330) configured to electrically connect the substrate of the camera module and the circuit board.

15. The wearable electronic device of any one of claims 1 to 14, wherein the body portions comprise:
a first side wall (321);
a second side wall (322) extending from one end of the first side wall; and
a third side wall (323) extending from the other end of the first side wall and disposed to be parallel to the second side wall, and
wherein the at least one protrusion portion comprises:
a first protrusion portion (3211) formed on the first side wall;
a second protrusion portion (3221) formed on the second side wall; and
a third protrusion portion (3231) formed on the third side wall.
